# EUROPÄISCHE PATENTANMELDUNG

(11) **EP 3 355 343 A1**
(43) Veröffentlichungstag der Anmeldung: **01.08.2018**
(21) Anmeldenummer: 18152013.1
(22) Anmeldetag: 17.01.2018
(51) Int. Cl.: H01L 21/607, B23K 20/10

(54) **VERFAHREN ZUR HERSTELLUNG VON DRAHTBONDVERBINDUNGEN UND VORRICHTUNG ZUR DURCHFÜHRUNG DES VERFAHRENS**

(30) Priorität: 30.01.2017 DE 102017101736
(71) Anmelder: F&K Delvotec Bondtechnik GmbH, 85521 Ottobrunn (DE)
(72) Erfinder: Schlicht, Franz, 83558 Maitenbeth (DE)
(74) Vertreter: Heinze, Ekkehard

(57) **Zusammenfassung**

Verfahren zur Herstellung von Drahtbondverbindungen zwischen einem elektronischen Bauelement oder einer Baugruppe und einem Träger unter Energieeintrag in einen Bonddraht durch einen Ultraschallwandler, wobei während des Energieeintrages zur Bildung einer ersten Drahtbondverbindung mindestens ein den momentanen Zustand des Bonddrahtes charakterisierender Bondparameter (Impedanz bzw. der Betribsstrom, Frequenz des Ultraschallwandlers, Derformation des Bonddrahtes) in Abhängigkeit von der Zeit gemessen, die Kurvenform der Zeitabhängigkeit anhand vorbestimmter Vergleichskriterien oder -kurven in drei Kurvenabschnitte und hiermit der Zeitablauf des Verfahrens in drei Phasen, nämlich eine Reinigungs-, eine Verschmelzungs- und eine Temper-Phase, differenziert wird und die in den Ultraschallwandler eingespeiste Energie und/oder eine auf den Bonddraht ausgeübte Bondkraft und/oder die Zeitdauer des Energieeintrags in mindestens einem Teilabschnitt mindestens der Reinigungs- und der Verschmelzungs-Phase, insbesondere jeder der Reinigungs-, Verschmelzungs- und Temper-Phase, messergebnisunabhängig in Quasi-Echtzeit während der Bildung der ersten Drahtbondverbindung oder während der nachfolgenden Bildung einer zweiten Drahtbondverbindung des gleichen Typs in Abhängigkeit von der Kurvenform im zugehörigen Kurvenabschnitt phasenspezifisch gesteuert wird.

## Beschreibung

Die Erfindung betrifft ein Verfahren zur Herstellung von Drahtbondverbindungen und eine Anordnung zur Durchführung des Verfahrens.

Drahtbondverbindungen werden in elektronischen Geräten aller Art zur Kontaktierung von elektronischen Bauelementen und insbesondere integrierten Schaltkreisen (Chips) massenhaft eingesetzt. Die Qualität dieser Verbindungen bestimmt die Leistung und Zuverlässigkeit der entsprechenden elektronischen Geräte in erheblichem Masse. Daher wird von den Herstellern der elektronischen Geräte der Qualitätskontrolle großes Augenmerk geschenkt, und die Hersteller von Drahtbondmaschinen stehen der Forderung nach immer zuverlässigeren Prüf- und Prozesskontrollsystemen gegenüber.

Eines der am weitesten entwickelten und verbreiteten Bondverfahren ist das Ultraschall-Drahtbonden ("Wedge Bonding"), das im Grunde eine Mikro-Reibschweisstechnik darstellt. Hierbei wird - wie beispielsweise in der US 4 619 397 der Anmelderin beschrieben - ein Aluminiumdraht in Kontakt mit einer Substratfläche, mit der er stoffschlüssig zu verbinden ist, durch einen Ultraschallwandler einer schnellen Schwingung unterzogen und gleichzeitig auf die Oberfläche angedrückt. Unter der Einwirkung der Druckkraft (Bondkraft) und der Schwingungsenergie (Bondenergie) wird eine auf der Oberfläche befindliche Oxidschicht aufgebrochen und unter starker Verformung und lokaler Erwärmung eine stoffschlüssige Grenzschichtverbindung hergestellt.

Genauere Ausführungen zu diesem Verfahren sind hier verzichtbar, da es dem Fachmann seit langem bestens bekannt ist.

Zur Prüfung der auf diese Weise hergestellten Bondverbindungen hat sich eine Vielzahl von Verfahren etabliert, von denen an dieser Stelle nur auf das Verfahren nach der US 4 984 730 der Anmelderin hingewiesen werden soll. In dieser Druckschrift wird ein Prüfverfahren beschrieben, welches auf der Erfassung einer Deformation des Bonddrahtes während des Bondprozesses und dem Vergleich mit einer Standard- bzw. Referenzkurve beruht. Zu weit von der Referenzkurve entfernt liegende aktuelle Deformationskurven werden als Indiz für ungenügende Qualität der Drahtbondverbindung gewertet, und die Erfassung solcher unzulässiger Abweichungen gibt Anlass einer Verfahrensunterbrechung und Neueinstellung relevanter Prozessparameter.

Ein in gewissem Sinn ähnliches Verfahren zum Prüfen von durch Ultraschall-Drahtbonden hergestellten Verbindungen wird in der DE 44 47 073 C1 beschrieben. Hier stellt die Festigkeit der Verbindung die maßgebende Größe für die Bondgüte dar. Es wird vorgeschlagen, als relevanten Parameter die Geschwindigkeit bzw. den zeitlichen Verlauf der Deformation des Bonddrahtes und den zeitlichen Verlauf der Bondwerkzeugamplitude (Wedge Amplitude) während des Bondvorganges zu erfassen und durch einen Vergleich mit Referenzdaten zu bewerten. Dieses Verfahren ermöglicht die Festigkeitsprüfung jeder einzelnen Verbindung ohne wesentlichen zusätzlichen Zeitaufwand.

In der US 5 314 105 der Anmelderin wird ein System zur Steuerung eines Ultraschall-Drahtbondprozesses vorgeschlagen, bei dem der Bondprozess in Echtzeit bzw. Quasi-Echtzeit aufgrund einer Erfassung der Zeitabhängigkeit der Deformation des Bonddrahtes gesteuert wird. Speziell wird vorgeschlagen, die in den Ultraschallwandler eingespeiste Energie solange auf einem hohen Pegel zu belassen, bis sich in der Kurve der Zeitabhängigkeit ein starker Anstieg der Deformation zeigt, und sie dann auf einen vorbestimmten niedrigeren Wert abzusenken. Weiterhin wird-in einer bevorzugten Verfahrensführung - vorgeschlagen, den Ultraschallwandler gänzlich abzuschalten, wenn die Drahtdeformation im wesentlichen einen vorbestimmten Endwert erreicht hat.

Die EP 0 275 877 B1 offenbart ebenfalls ein Bondverfahren, bei dem eine Sensorik zur Messung der Bondkraft und zur Messung der Ultraschallamplitude vorgesehen ist und die Steuerung des Bondprozesses zusätzlich anhand der Temperatur eines zu bondenden Bausteins durchgeführt wird.

Eine hierauf aufbauende neuere Lösung ist etwa in der EP 2 218 097 B1 beschrieben. Diese nutzt einen bereits bei der o.g. EP 0 275 877 A vorgesehenen Piezosensor dazu, eine Querdehnung senkrecht zur Ultraschallwelle zu erfassen. Zusätzlich wird ein Spannungssensor eingesetzt, um ein Spannungsverlauf-Messsignal zur Erfassung, das den zeitlichen Verlauf der Generatorspannung repräsentiert. Das Piezosensor-Signal und das Spannungssensor-Signal werden einem Phasenkomparator zugeführt, und es wird die Phasendifferenz zwischen beiden erfasst. Ein Phasenregler (dem der erwähnte Phasenkomparator zugeordnet ist) soll die Werkzeug-Schwingungsfrequenz am US-Generator so verringern, dass möglichst mechanische Resonanz in der Transducer-Bondwerkzeug-Einheit auftritt. Das völlige Verschwinden der Phasendifferenz und somit ideale Resonanz werden in den Hauptansprüchen allerdings nicht definitiv festgelegt.

In Ausführungsformen wird ein "Reibungswert" beim Bondvorgang ermittelt und zur Steuerung und/oder Regelung des Bondvorganges (beispielsweise von Bondkraft, Ultraschallleistung, Bondzeit und/oder US-Frequenz) genutzt, und speziell wird ein Ist-Zeitverlauf dieses Reibungswertes mit einem gespeicherten Soll-Zeitverlauf verglichen und daraus ein die Qualität des Bondvorganges bzw. der Bondverbindung kennzeichnender Qualitätswert abgeleitet. Dieser kann wiederum bevorzugt zur Steuerung nachfolgender Bondvorgänge genutzt werden. Entsprechend dieser bevorzugten Ausgestaltung umfasst die Bondvorrichtung eine entsprechende Speichereinheit für den Soll-Zeitverlauf und eine Steuereinrichtung, die den Zeitverlauf des Reibungswertes bzw. das Vergleichsergebnis mit dem Soll-Zeitverlauf in ein Steuer- oder Regelsignal umsetzt.

Die WO 02/070185 A1 nutzt mehrere Sensoren zur Erfassung von Messsignalen von mehreren während des Bondens variablen Parametern zur Beurteilung der Bondqualität und/oder zur Beeinflussung des Bondens. Es sollen der zeitliche Verlauf der Parameter dargestellt und aus dem zeitlichen Verlauf abgeleitete Größen gebildet und durch Vergleich mit einem jeweils zugeordneten Soll-Verlauf sog. Abweichungs-Verläufe ermittelt werden. Weiterhin soll eine statistische Auswertung für die Soll-Verläufe vorgenommen und eine verwickelte Konfidenz-Betrachtung angestellt werden. Schließlich wird aus einem oder mehreren der Abweichungs-Verläufe jeweils ein Qualitätsindex für den Bondvorgang bzw. die Bondverbindung gewonnen, und ein zusammenfassender Qualitätsindex wird zur Steuerung der Regelung von nachfolgenden Bondprozessen genutzt.

Hierauf aufbauend, wird in der EP 2 385 545 B1 gelehrt, dass die Messparameter wenigstens die Geschwindigkeit der Werkzeugspitze und die Generatorspannung des US-Generators umfassen und die Ist-Verläufe der aus den Parametern abgeleiteten Größen wenigstens die mechanische Admittanz als Quotient aus Werkzeuggeschwindigkeit und Generatorspannung umfassen. Nur im Verfahrensanspruch ist zusätzlich erwähnt, dass "ein oder mehrere" Abweichungs-Verläufe "bezüglich der verschiedenen Elemente des Abweichungs-Vektors veränderlich gewichtet werden" - was auch immer das heißt.

Mehrere abhängige Ansprüche jener Druckschrift spezifizieren entweder die benutzten Zeitverläufe bzw. Abweichungsverläufe und deren Nutzung innerhalb eines laufenden Bondvorganges oder für nachfolgende Bondvorgänge, wobei auch "Lernphasen" und die Nutzung eines Bondparameter-Referenzsystems erwähnt werden. Weiterhin wird vorgeschlagen, dass mit weiteren Sensoren Parameter wie Stromstärke oder Drahtverformung oder Ultraschallfrequenz bzw. Resonanzfrequenz erfasst werden sollen (Verfahrensanspruch) bzw. dass entsprechende Sensoren vorgesehen sind (Vorrichtungsanspruch).

Der vorliegenden Erfindung liegt die Aufgabe zugrunde, ein gegenüber diesem Stand der Technik weiter verbessertes Verfahren und eine entsprechende Anordnung zur Bondprozesssteuerung anzugeben, mit denen insbesondere Substrate mit sehr unterschiedlicher und ggfs. auch mangelhafter Oberflächenqualität mit zufriedenstellender Qualität reproduzierbar gebondet werden können.

Diese Aufgabe wird in ihrem Verfahrensaspekt durch ein Verfahren mit den Merkmalen des Anspruchs 1 und in ihrem Vorrichtungsaspekt durch eine Vorrichtung mit den Merkmalen des Anspruchs 12 gelöst. Zweckmäßige Fortbildungen des Erfindungsgedankens sind Gegenstand der jeweiligen abhängigen Ansprüche.

Die Erfindung baut auf dem Gedanken auf, bei der Steuerung eines Ultraschall-Bondverfahrens dessen Zeitablauf in drei Phasen, nämlich eine Aktivierungs-, eine Verschweißungs- und eine Temper-Phase zu differenzieren, wozu die Kurvenform der Zeitabhängigkeit mindestens eines den momentanen Zustand des Bonddrahtes charakterisierenden Bondparameters genutzt wird. Sie schließt weiter den Gedanken ein, die in den Ultraschallwandler eingespeiste Energie und/oder eine auf den Bonddraht ausgeübte Bondkraft und/oder die Zeitdauer des Energieeintrags in mindestens einem Teilabschnitt mindestens der Aktivierungs- und der Verschweißungs-Phase, insbesondere jeder der Aktivierungs-, Verschweißungs- und Temper-Phase, in Quasi-Echtzeit messergebnisabhängig zu steuern. Speziell kann dies erfindungsgemäß entweder "online" während der Bildung der ersten Drahtbondverbindung oder während der nachfolgenden Bildung einer zweiten Drahtbondverbindung des gleichen Typs in Abhängigkeit von der Kurvenform im der jeweiligen Phase zugehörigen Kurvenabschnitt phasen-spezifisch erfolgen.

Insbesondere wird die Zeitdauer des Energieeintrags in der Aktivierungs-Phase und somit der Übergangspunkt zur Verschweißungs-Phase variabel in Abhängigkeit von der Kurvenform des Zeitverlaufes des mindestens einen Bondparameters variabel gesteuert. Als Sonderfall ist hier zu nennen, dass auch eine Beendigung des Energieeintrags nach Ablauf einer vordefinierten Zeitdauer und somit ein Abbruch des gesamten Bondvorganges insoweit im Rahmen der Erfindung liegt, als dieser in Abhängigkeit von der Erfassung und Prüfung der Zeitabhängigkeit mindestens eines Bondparameters gesteuert wird.

In bevorzugten Ausführungen wird/werden der oder die jeweils gesteuerte Bondparameter auf einen von mehreren vorgespeicherten Werten eingestellt, denen jeweils eine Vergleichs-Kurvenform im zugehörigen Kurvenabschnitt zugeordnet ist. Hierbei wird derjenige Wert des gesteuerten Bondparameters eingestellt, dessen zugeordnete Vergleichs-Kurvenform des herangezogenen Messwertes der aktuell erfassten Kurvenform im Kurvenabschnitt am nächsten kommt.

In einer Variante des vorgeschlagenen Verfahrens wird/werden der oder die gesteuerten Bondparameter bei der nachfolgenden Bildung einer zweiten Drahtbondverbindung des gleichen Typs in deren Aktivierungs-, Verschweißungs- und Temper-Phase jeweils in Abhängigkeit vom zugehörigen Kurvenabschnitt der bei der Bildung der ersten Drahtbondverbindung erfassten Zeitabhängigkeit oder mindestens der Zeitabhängigkeit in einem Beobachtungsfenster gesteuert.

Wie bereits angemerkt, kann alternativ bereits während der Bildung der aktuellen ("ersten") Drahtbondverbindung die Kurvenform in einem anfänglichen Teilabschnitt mindestens einer, insbesondere jeder, der Aktivierungs- und Verschweißungs-Phase erfasst und ausgewertet und das Auswertungsergebnis in Quasi-Echtzeit unmittelbar zur Festlegung des oder der gesteuerten Bondparameters während eines späteren Teilabschnitts der jeweiligen Phase der Bildung der ersten Drahtbondverbindung genutzt werden.

In einer weiteren Ausführung der Erfindung umfasst die Auswertung der Kurvenform der Gesamt-Zeitabhängigkeit zur Differenzierung in die drei Kurvenabschnitte und/oder die Auswertung zur Festlegung der Werte des oder der gesteuerten Bondparameter den Vergleich mit mindestens einer gespeicherten Gesamt-Referenzkurve, insbesondere mit einer Schar von Gesamt-Referenzkurven eines "optimalen" Bondprozesses bzw. von an definierte Bedingungen angepassten Bondprozessen.

In bevorzugten Ausführungen der Erfindung wird als den Zustand des Bonddrahtes charakterisierender Bondparameter die Impedanz (bzw. der Betriebsstrom) und wahlweise Frequenz des Ultraschallwandlers und/oder eine Deformation des Bonddrahtes gemessen.

Im Rahmen der Erfindung ist speziell vorgesehen, dass in mindestens einer der drei Phasen des Verfahrensablaufes (ausschließlich oder jedenfalls primär) eine andere den Zustand des Bonddrahtes charakterisierende Auswahl von Bondparametern als in mindestens einer anderen Phase erfasst und der Steuerung zugrunde gelegt wird. Insbesondere werden in der Aktivierungs-Phase die Deformation des Bonddrahtes und die Impedanz und optional Frequenz des Ultraschallwandlers erfasst, während in der Verschweißungs-Phase nur die Deformation des Bonddrahtes erfasst wird.

In einer besonders bevorzugten Ausgestaltung wird die Zeitdauer der Aktivierungs-Phase und somit der Übergangspunkt zur Verschweißungs-Phase primär aufgrund der Auswertung der Drahtdeformations-Kurvenform, insbesondere eines Vergleichs derselben mit einer entsprechenden Referenzkurve, bestimmt.

In einer weiteren Ausgestaltung erfolgt für jede der Aktivierungs-, Verschweißungs- und Temper-Phase eine phasen-spezifische Festlegung der in den Ultraschallwandler eingespeisten Energie und der Bondkraft. Insbesondere geschieht dies als in Quasi-Echtzeit ausgeführter Berechnungsvorgang oder Auswahl aus einem von mehreren vorgespeicherten Steuergrößensätze in Abhängigkeit von der Kurvenform.

In weiteren Ausführungen des Verfahrens weist die Steuerung der eingespeisten Energie und/oder der Bondkraft und/oder der Dauer des Energieeintrags mindestens eine Regelungskomponente auf.

Die vorgeschlagene Anordnung zeichnet sich zum einen dadurch aus, dass eine Auswertungseinrichtung zur Auswertung der Bondparameter-Zeitabhängigkeit einer Auswertungseinrichtung zur Auswertung der Kurvenform der Zeitabhängigkeit des oder jedes gemessenen Bondparametes vorhanden ist, die eine Kurvenform-Differenzierungseinrichtung zur Differenzierung der Gesamt-Zeitabhängigkeit in drei durch einen jeweils charakteristischen Verlauf unterschiedene Kurvenabschnitte umfasst. Weiterhin zeichnet sich die Anordnung vorzugsweise dadurch aus, dass in einer Bondparameter-Steuereinheit differenzierte Steuergrößensätze jeweils für die Aktivierungs-, Verschweißungs- und Temper-Phase des Bondprozesses zur phasenweisen Auswahl in Abhängigkeit von Ausgangsdaten der Auswertungseinrichtung gespeichert sind. Alternativ kann eine, insbesondere zum Echtzeitbetrieb fähige, Berechnungseinheit zur ab-initio-Berechnung eines anzuwendenden Steuergrößensatzes aufgrund der aktuell ermittelten Zeitabhängigkeit (Messparameter-Kurvenform) anhand von Erfahrungswerten vorgesehen sein.

In einer Ausführung der Anordnung weist die Auswertungseinrichtung einen Referenzkurvenspeicher zur Speicherung von in die drei Kurvenabschnitte differenzierten Referenzkurven und eine Vergleichereinheit zum Vergleich der Kurvenform der aktuellen Zeitabhängigkeit des oder der erfassten Bondparameter mit den Referenzkurven und zur Ausgabe von die drei Zeitabschnitte definierenden Daten auf.

In einer weiteren Ausführung weist die Bondparameter-Steuereinrichtung ein Rückkopplungsglied zur Realisierung einer Regelungskomponente bei der Steuerung mindestens eines Bondparameters auf.

Vorteile und Zweckmäßigkeiten der Erfindung ergeben sich um Übrigen aus der nachfolgenden Beschreibung von bevorzugten Ausführungsbeispielen und -aspekten anhand der Figuren. Von diesen zeigen:
- Fig. 1: eine schematische Darstellung einer ersten Anordnung zur Durchführung des erfindungsgemäßen Verfahrens in Art eines Funktions-Blockschaltbildes,
- Fig. 2: eine schematische Darstellung einer zweiten Anordnung zur Durchführung des erfindungsgemäßen Verfahrens in Art eines Funktions-Blockschaltbildes und
- Fig. 3: eine schematische grafische Darstellung des Zeitverlaufes eines Bondprozesses anhand der relevanten Mess- bzw. Steuergrößen.

Im Ablauf der Herstellung einer Drahtbondverbindung auf einer Kontaktfläche eines elektronischen Bauelements oder einer Baugruppe werden üblicherweise drei Phasen unterschieden: (a) eine Reinigungs- oder Aktivierungs-Phase, in der durch die mittels des Ultraschallwandlers erzeugte Schwingung des Bonddrahts auf der Substratoberfläche eine Aktivierung der Grenzfläche stattfindet; (b) eine Phase der stofflichen Vermischung zwischen Bonddraht und Material der Kontaktfläche, also der eigentlichen Verschweißung (hier Verschweißungs- bzw. Deformations-Phase genannt), und schließlich (c) eine Temper-Phase, in der die erzeugte Schweißverbindung thermisch stabilisiert wird. Eine feinere Unterteilung des Bondprozesses ist möglich und für gewisse Zwecke auch sinnvoll, wird aber im Kontext der vorliegenden Erfindung nicht vorgenommen.

Während üblicherweise jede der drei Phasen mit einem vordefinierten Satz an Bondparametern ausgeführt wird, wird hier vorgeschlagen, nicht nur in der Verschweißungs-Phase, sondern zumindest auch in der vorangehenden Aktivierungs-Phase zumindest einen Teil der Bondparameter (also insbesondere die in den Ultraschallwandler eingespeiste Energie und/oder die auf den Bonddraht ausgeübte Bondkraft und/oder die Zeitdauer des Energieeintrags in den Bonddraht) in Abhängigkeit von einer Zustandserfassung der Verbindungspartner bzw. der sich ausbildenden Verbindung messwertabhängig zu steuern, und zwar insbesondere unter Verfolgung der erfassten Zeitabhängigkeit mindestens einer relevanten Messgröße.

Die Qualität einer Drahtbondverbindung hängt bekanntlich entscheidend von der richtigen Einstellung der Bondparameter ab, und zwar nicht nur in der Verschweißungs- bzw. Deformations-Phase, sondern (abhängig von der Beschaffenheit der Verbindungspartner) auch in der Aktivierungs- und der Temper-Phase. Insbesondere können sub-optimale Oberflächenbeschaffenheiten (Oxidbelegung, Kontaminationen, Rauheit, lokale Verhärtungen etc.) durch geeignete Einstellung der Bondparameter in gewissen Grenzen so "kompensiert" werden, dass sich eine qualitativ hochwertige Bondverbindung erzeugen lässt.

In einer Ausführung des Verfahrens ist in der Reinigungs- bzw. Aktivierungs-Phase eine reibende, "schrubbende" Relativbewegung von Draht und Kontaktfläche erwünscht; es wird also sinnvollerweise eine große Bewegungsamplitude des Drahtes (über entsprechende Energiezufuhr an den Transducer) und eine kleine Bondkraft eingestellt. Hierdurch wird eine Verschweißung bzw. Verschmelzung zunächst verhindert, bis eine zumindest lokal hinreichend aktivierte Grenzfläche ausgebildet ist, so dass sich erste Bondinseln bzw. lokale Verschweißungen ausbilden. Dies manifestiert sich in einer zunehmenden Dämpfung der Schwingung des Bonddrahtes, messtechnisch also in einer steigenden Impedanz (bzw. einem sinkenden gemessenen Strom) am Transducer und ansteigende Transducer-Frequenz. Zugleich findet eine initiale Deformation des Bonddrahtes statt, die sich ebenfalls messtechnisch erfassen lässt. In einer aus derzeitiger Sicht vorteilhaften Verfahrensführung werden die Ultraschallleistung in dieser Phase auf einem niedrigen bis mittleren Wert und die Bondkraft auf einem niedrigen Wert gehalten.

Sobald sich die gereinigten und dadurch aktivierten gegenüberliegenden Oberflächen von Bonddraht und Kontaktfläche zu verbinden beginnen, wird die Relativbewegung der sich berührenden Oberflächen gehindert und eine Scherwirkung innerhalb des Bonddrahtes hervorgerufen. Hieraus resultiert eine Aufweichung der Drahtstruktur; das Material fließt unter dem Bondwerkzeug. Dies lässt sich messtechnisch in einer signifikanten Deformation erfassen, die sich als "Absinken" des Wedges zeitabhängig verfolgen lässt. Die Kurvenform der Zeitabhängigkeit der Deformation lässt sich als Stellgröße verwenden. In einer unter Normalbedingungen vorteilhaften Ausgestaltung dieser Phase wird in einem ersten Teilabschnitt die Bondkraft erhöht und die Ultraschallleistung so eingeregelt, dass eine vorbestimmte Deformationsrate eingehalten wird. Bei beobachteter Unter- oder Überschreitung dieser wünschenswerten Deformationsrate wird die Ultraschallleistung in bestimmter geeigneter Weise (etwa mit bestimmter Regelgeschwindigkeit nach oben und unten, minimaler/maximaler Regelamplitude etc.) erhöht oder verringert.

Mit zunehmender Deformation kann eine Verfestigung des Drahtes eintreten, so dass sich auch die erwünsche Deformationsrate ändert. Bei einem zweiten Teilabschnitt der Verschweißungs-Phase wird ggfs. auf einen anderen Steuergrößensatz umgeschaltet, wobei als Schaltschwelle hierfür ein vorab definierter Betrag der Drahtdeformation genutzt werden kann. Es ist also auch möglich, neben der Kurvenform des Zeitverlaufs der Deformation (oder einer anderen Mess- bzw. Stellgröße) einen einzelnen absoluten oder relativen Wert zur Auslösung eines Steuervorganges zu nutzen. Auch als Auslöser zur Beendigung der Verschweißungs-Phase (durch Umschalten auf einen anderen Steuergrößensatz) kann die Erreichung eines vorab definierten Deformationsbetrages des Bonddrahtes genutzt werden.

In der Temper-Phase wird mit der Ultraschallschwingung eine fortdauernde Scherwirkung auf die Bondzone (Verschweißungszone) ausgeübt, wodurch das Ausheilen von Gitterversetzungen und Fehlstellen ermöglicht wird. Hierzu wird aus derzeitiger Sicht vorteilhafter Weise ein geringerer Pegel der Ultraschallschwingung eingestellt und für eine vorgegebene Zeit (oder auch bis zur Erreichung einer vorgegebenen Gesamt-Bondprozesszeit) konstant gehalten. Impedanz und Frequenz können hier überwacht werden, um ein etwaiges "Rutschen" des Wedges über die Bonddrahtoberfläche, welches Überbondungen oder sog. "Burnt Bonds" erzeugen würde, zu erkennen und durch Veränderung der Bondkraft und ggfs. auch Ultraschallamplitude möglichst zu unterbinden. Obwohl in der Temper-Phase grundsätzlich mit einem fest vorgegebenen Steuergrößensatz gearbeitet werden könnte, ist auch hier also eine messwertabhängige Bondprozesssteuerung ggfs. von Vorteil.

In Ausführungen des vorgeschlagenen Verfahrensablaufs kann die Zeitabhängigkeit der relevanten Messgrößen in für die Prozesssteuerung ausreichender und die Anforderungen an die Messdatenverarbeitung reduzierender Weise mit Beobachtungsfenstern gearbeitet werden. Diese können weitgehend Teilabschnitten der einzelnen Phasen entsprechen oder auch deutlich kürzer sein und sind insbesondere in ihrer Lage auf der Zeitachse variabel wählbar. Die Lage kann ggfs. bereits bei Prozessbeginn aufgrund von Produktdaten des Bonddrahts und/oder der Beschaffenheit der Kontaktfläche des elektronischen Bauelements vorgewählt werden; sie kann aber in anderen Ausführungen auch wiederum abhängig von anfänglich im Prozess gewonnenen Messergebnissen variiert werden.

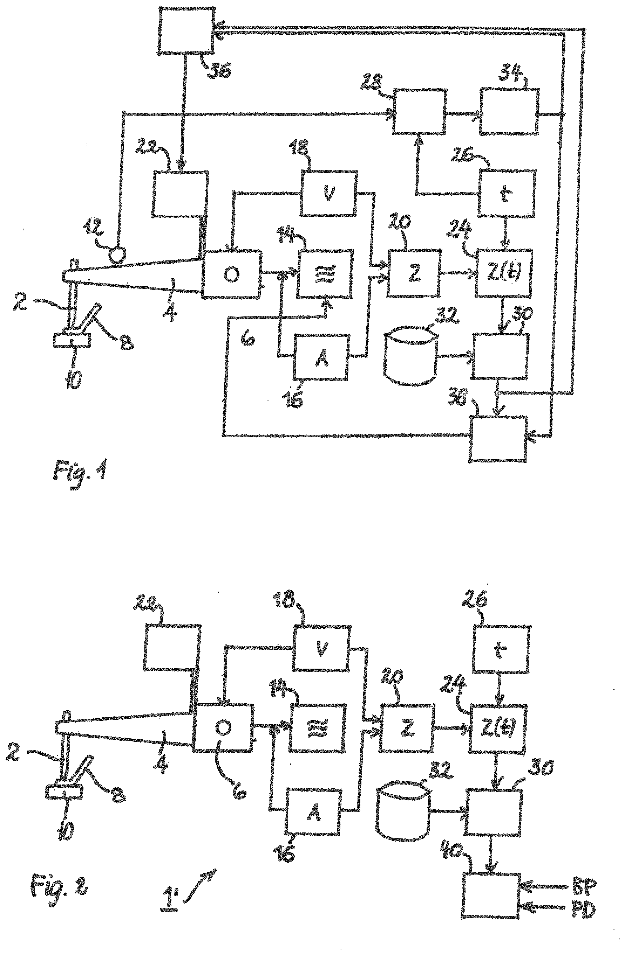

In Fig. 1 ist schematisch eine Anordnung 1 zur Durchführung eines in Abhängigkeit von einer Deformations-Zeit-Kurve und einer Impedanz-Zeit-Kurve gesteuerten Bondprozesses dargestellt, die typischerweise in einen (nicht insgesamt dargestellten) Drahtbonder integriert ist. Von den üblichen Komponenten eines Drahtbonders sind ein Wedge 2 und ein Horn 4 eines Ultraschallwandlers 6, welches an dem Wedge angebracht ist, dargestellt. Der Wedge dient zum Herstellen einer Bondverbindung mittels eines Bonddrahtes 8 auf einem Substrat 10.

Dem Horn 4 des Ultraschallwandlers (Transducers) 6 ist ein - an sich bekannter - Deformationssensor 12 zugeordnet. In eine Stromversorgung 14 des Transducers 6 sind eine Stromstärke-Messeinrichtung 16 und eine Spannungsmesseinrichtung 18 integriert, welche ausgangsseitig mit einer Impedanzbestimmungseinrichtung 20 zur Berechnung momentaner Impedanzwerte verbunden sind. Dem Transducer 6 ist ein Bondkopfantrieb 22 zugeordnet, der eine vorbestimmte Andruckkraft (Bondkraft) erzeugt, die das Bondwerkzeug 2 auf den Bonddraht 8 ausübt. Mit dem Ausgang der Impedanzbestimmungseinrichtung 20 ist eine Impedanz-Registriereinrichtung 24 zur Registrierung der Zeitabhängigkeit der Impedanz verbunden, welche über einen weiteren Eingang mit einem Zeitgeber 26 verbunden ist. Der Deformationssensor 12 ist mit dem Eingang einer Deformations-Registriereinrichtung 28 zur Registrierung der Zeitabhängigkeit der Bonddrahtdeformation verbunden, welche ebenfalls ein Zeitsignal von dem Zeitgeber 26 erhält.

Die Impedanz-Registriereinrichtung 24 ist ausgangsseitig mit einer Impedanz-Auswertungseinrichtung 30 verbunden, welche über einen weiteren Eingang mit einer Referenz-Datenbasis 32 verbunden ist. Der Ausgang der Deformations-Registriereinrichtung 28 ist mit einer Deformations-Auswertungseinrichtung 34 verbunden. Beide Auswertungseinrichtungen 30 und 34 sind gemeinsam einerseits mit einer Bondkraft-Steuereinheit 36 und andererseits mit einer Bondenergie-Steuereinheit 38 verbunden. Die Bondkraft-Steuereinheit 36 wirkt auf den Bondkopfantrieb 22 zur schnellen Steuerung der Bondkraft ein, und die Bondenergie-Steuereinheit 38 wirkt auf die Stromversorgung 14 des Transducers 6 zur schnellen Steuerung der Bondenergie (Ultraschall-Schwingungsenergie) ein.

Die Funktionsweise der Mess- und Steueranordnung 1 ergibt sich bereits aus den obigen allgemeinen Ausführungen zum vorgeschlagenen Verfahren und wird daher insoweit hier nicht nochmals beschrieben. Es wird darauf hingewiesen, dass in den Auswertungseinrichtungen 30 und 34 und den Steuereinheiten 36 und 38 Auswertungs- bzw. Steueralgorithmen gespeichert sind, die aus experimentell an einer Mehrzahl von Substraten mit verschiedenen Bonddrähten und Verfahrensparameter-Konstellationen gewonnenen Messkurven der Transducerimpedanz und Drahtbonddeformation und zugehörigen üblichen Qualitätsuntersuchungen abgeleitet sind. Derartige Messungen und Qualitätsprüfungen sind dem Fachmann der Bondtechnik geläufig, so dass er konkrete Steueralgorithmen für konkrete Bauelemente, Substrate und Bonddrähte selbst finden kann.

Fig. 2 zeigt eine gegenüber der Mess- und Steueranordnung 1 nach Fig. 1 wesentlich vereinfachte Teil-Darstellung einer weiteren Testanordnung 1'. Hierbei hat ein Drahtbonder mit dem üblichen Aufbau - von dem in der Figur wiederum das Bondwerkzeug 2, das Horn 4, der Transducer 6 und der Bondkopfantrieb 22 gezeigt sind - zusätzlich die Stromstärke-Messeinrichtung 16, Spannungmesseinrichtung 18 und Impedanzbestimmungseinrichtung 20 sowie Impedanz-Registriereinrichtung 24 und Impedanz-Auswertungseinrichtung 30 mit zugehöriger Datenbasis 32. Nicht aber vorhanden sind die in Fig. 1 dargestellten Mittel zur Deformationserfassung und -auswertung und nicht gezeigt sind Mittel zur Online-Steuerung des Bondprozesses.

Statt dessen ist hier gezeigt, dass die Impedanzauswertungseinrichtung 30 hier ausgangsseitig mit einer Speichereinrichtung 40' zur Speicherung des zeitlichen Verlaufs der Impendanz verbunden ist. Der Speichereinrichtung 40' werden außerdem aus der (hier nicht gezeigten) Steuerung des Bondprozesses die Zeitabhängigkeit der eingestellten Bondparameter sowie aus der Eingangskontrolle die prozessrelevanten Daten des gebondeten Bauelements und des Bonddrahtes zugeführt, was in der Figur durch mit den Buchstaben BP und PD bezeichnete Pfeile symbolisiert ist. In der Speichereinrichtung können somit vollständige Vergleichs-Datensätze bzw. Gesamt-Referenzkurven als Basis für künftige Bondprozesssteuerungen abgelegt werden.

Auch die Funktion dieser Ausführungsform ergibt sich aus den obigen Erläuterungen zum vorgeschlagenen Verfahren.

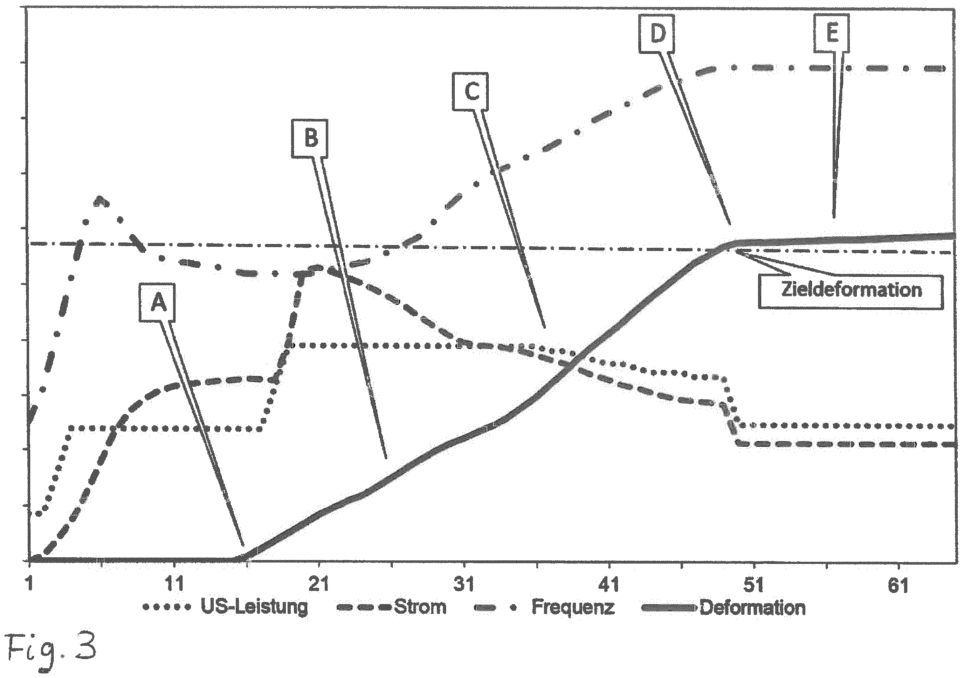

Fig. 3 zeigt schematisch die Zeitabhängigkeit relevanter Mess- und Steuergrößen eines beispielhaften Bondprozesses, zur exemplarischen Erläuterung des vorgeschlagenen Verfahrens. Die X-Achse ist in beliebigen Einheiten bezeichnet; die punktierte Linie stellt die Ultraschall-Leistung, die gestrichelte Linie den Transducer-Strom, (repräsentativ für die Impedanz), die strichpunktierte Linie die Ultraschall-Frequenz und die durchgezogene Linie die Bonddrahtdeformation dar. Es handelt sich hierbei nicht um reale Mess- bzw. Steuersignalverläufe, sondern um zu Erklärungszwecken geglättete Kurven.

Der Bondprozess beginnt mit einer Aktivierungs- bzw. Reinigungsphase, in der der Bonddraht (und über diesen das darunterliegende Substrat) mit relativ niedriger Ultraschallleistung beaufschlagt wird. Am mit A bezeichneten Punkt setzt eine Deformation des Bonddrahtes ein, und daraufhin erfolgt eine Umschaltung in die zweite Phase des Bondprozesses, die Verschweißungs- bzw. Verschmelzungsphase. Hier ist die Ultraschall-Leistung erhöht, und auch der gemessene Strom steigt sprunghaft an, während die Deformation des Bonddrahtes im Wesentlichen linear zunimmt. Diese Phase wird daher auch als Deformationsphase bezeichnet. In dieser Phase liegt der mit B bezeichnete Punkt.

Im gezeigten Beispiel erfolgt an einem Punkt C eine leichte Verringerung der Ultraschall-Leistung, als Reaktion darauf, dass der Verlauf der Deformationskurve von demjenigen einer Sollkurve dahingehend abgewichen ist, dass die Steigung der Ist-Deformationskurve größer als diejenige der Soll-Deformationskurve war. Hierdurch wird das weitere Fortschreiten der Bonddrahtdeformation unter Kontrolle gehalten, bis an einem Punkt D eine Ziel-Deformation erreicht ist (in der Figur als horizontale strichpunktierte Linie dargestellt).

Bei Feststellung dieses Umstandes wird die Ultraschall-Leistung signifikant verringert, und auch der gemessene Strom verringert sich entsprechend. Dies stellt den Übergang in die sog. Temperphase dar, in der mit konstantem Eintrag von Ultraschall-Energie bis zum Ablauf einer vorgegebenen Maximal-Zeitdauer eine thermische Nachbearbeitung der Verschweißungsstelle bzw. des Bonds erfolgt.

Im Übrigen ist die Ausführung der Erfindung auch in einer Vielzahl von Abwandlungen der hier gezeigten Beispiele und weiter oben hervorgehobenen Aspekte der Erfindung möglich.

## Patentansprüche

1. Verfahren zur Herstellung von Drahtbondverbindungen zwischen einem elektronischen Bauelement oder einer Baugruppe und einem Träger unter Energieeintrag in einen Bonddraht durch einen Ultraschallwandler,
wobei
während des Energieeintrages zur Bildung einer ersten Drahtbondverbindung mindestens ein den momentanen Zustand des Bonddrahtes charakterisierender Bondparameter in Abhängigkeit von der Zeit gemessen, die Kurvenform der Zeitabhängigkeit anhand vorbestimmter Vergleichskriterien oder -kurven in drei Kurvenabschnitte und hiermit der Zeitablauf des Verfahrens in drei Phasen, nämlich eine Reinigungs-, eine Verschmelzungs- und eine Temper-Phase, differenziert wird und
die in den Ultraschallwandler eingespeiste Energie und/oder eine auf den Bonddraht ausgeübte Bondkraft und/oder die Zeitdauer des Energieeintrags in mindestens einem Teilabschnitt mindestens der Reinigungs- und der Verschmelzungs-Phase, insbesondere jeder der Reinigungs-, Verschmelzungs- und Temper-Phase, messergebnisunabhängig in Quasi-Echtzeit während der Bildung der ersten Drahtbondverbindung oder während der nachfolgenden Bildung einer zweiten Drahtbondverbindung des gleichen Typs in Abhängigkeit von der Kurvenform im zugehörigen Kurvenabschnitt phasen-spezifisch gesteuert wird.

2. Verfahren nach Anspruch 1, wobei die Zeitdauer des Energieeintrags in der Reinigungs-Phase und somit der Übergangspunkt zur Verschmelzungs-Phase variabel in Abhängigkeit von der Kurvenform des mindestens einen Bondparameters variabel gesteuert wird.

3. Verfahren nach Anspruch 1 oder 2, wobei der oder die jeweils gesteuerte Bondparameter auf einen von mehreren vorgespeicherten Werten eingestellt wird/werden, denen jeweils eine Vergleichs-Kurvenform im zugehörigen Kurvenabschnitt zugeordnet ist, wobei derjenige Wert des gesteuerten Bondparameters eingestellt wird, dessen zugeordnete Vergleichs-Kurvenform der aktuell erfassten Kurvenform im Kurvenabschnitt am nächsten kommt.

4. Verfahren nach einem der Ansprüche 1 bis 3, wobei der oder die gesteuerten Bondparameter bei der nachfolgenden Bildung einer zweiten Drahtbondverbindung des gleichen Typs in deren gesamter Reinigungs-, Verschmelzungs- und Temper-Phase jeweils in Abhängigkeit von mindestens einem Teilabschnitt des zugehörigen Kurvenabschnitts der bei der Bildung der ersten Drahtbondverbindung erfassten Zeitabhängigkeit gesteuert wird.

5. Verfahren nach einem der Ansprüche 1 bis 3, wobei während der Bildung der ersten Drahtbondverbindung die Kurvenform in einem anfänglichen Teilabschnitt mindestens einer, insbesondere jeder, der Reinigungs- und Verschmelzungs-Phase erfasst und ausgewertet und das Auswertungsergebnis in Quasi-Echtzeit unmittelbar zur Festlegung des oder der gesteuerten Bondparameters während eines späteren Teilabschnitts der jeweiligen Phase der Bildung der ersten Drahtbondverbindung genutzt wird.

6. Verfahren nach einem der vorangehenden Ansprüche, wobei die Auswertung der Kurvenform der Gesamt-Zeitabhängigkeit zur Differenzierung in die drei Kurvenabschnitte und/oder die Auswertung zur Festlegung der Werte des oder der gesteuerten Bondparameter den Vergleich mit mindestens einer gespeicherten Gesamt-Referenzkurve, insbesondere mit einer Schar von Gesamt-Referenzkurven, umfasst.

7. Verfahren nach einem der vorangehenden Ansprüche, wobei als den Zustand des Bonddrahtes charakterisierender Bondparameter die Impedanz und wahlweise Frequenz des Ultraschallwandlers und/oder eine Deformation des Bonddrahtes gemessen wird.

8. Verfahren nach einem der vorangehenden Ansprüche, wobei in mindestens einer der drei Phasen des Verfahrensablaufes eine andere den Zustand des Bonddrahtes charakterisierende Auswahl von Bondparametern als in mindestens einer anderen Phase erfasst und der Steuerung zugrunde gelegt wird, wobei insbesondere in der Reinigungs-Phase die Deformation des Bonddrahtes und die Impedanz und Frequenz des Ultraschallwandlers erfasst werden, während in der Verschmelzungs-Phase die Deformation des Bonddrahtes erfasst wird.

9. Verfahren nach einem der Ansprüche 2 bis 7 und Anspruch 8, wobei die Zeitdauer der Reinigungs-Phase und somit der Übergangspunkt zur Verschmelzungs-Phase aufgrund der Auswertung der Drahtdeformations-Kurvenform, insbesondere eines Vergleichs derselben mit einer entsprechenden Referenzkurve, bestimmt wird.

10. Verfahren nach einem der vorangehenden Ansprüche, wobei für jede der Reinigungs-, Verschmelzungs- und Temper-Phase eine phasen-spezifische Festlegung der in den Ultraschallwandler eingespeisten Energie und der Bondkraft, insbesondere als in Quasi-Echtzeit ausgeführter Berechnungsvorgang oder Auswahl aus einem von mehreren vorgespeicherten Steuergrößensätze in Abhängigkeit von der Kurvenform, erfolgt.

11. Verfahren nach einem der vorangehenden Ansprüche, wobei die Steuerung der eingespeisten Energie und/oder der Bondkraft und/oder der Dauer des Energieeintrags mindestens eine Regelungskomponente aufweist.

12. Anordnung zur Durchführung des Verfahrens nach einem der vorangehenden Ansprüche, mit
- mindestens einer Messeinrichtung für den den momentanen Zustand des Bonddrahtes charakterisierenden Bondparameter,
- einer mit dem Ausgang der oder jeder Messeinrichtung verbundenen Registriereinrichtung zur Registrierung der Zeitabhängigkeit des Ausgangssignals der Messeinrichtung während der Zeitdauer des Energieeintrags,
- einer Auswertungseinrichtung zur Auswertung der Kurvenform der Zeitabhängigkeit des oder jedes gemessenen Bondparametes, wobei die Auswertungseinrichtung eine Kurvenform-Differenzierungseinrichtung zur Differenzierung der Gesamt-Zeitabhängigkeit in drei durch einen jeweils charakteristischen Verlauf unterschiedene Kurvenabschnitte umfasst, und
- einer mit dem Ausgang der Auswertungseinrichtung verbundenen Bondparameter-Steuereinheit, wobei in der Bondparameter-Steuereinheit zur phasen-spezifischen Steuerung der eingespeisten Energie und/oder der Bondkraft und/oder der Dauer des Energieeintrags insbesondere differenzierte Steuergrößensätze jeweils für die Reinigungs-, Verschmelzungs- und Temper-Phase des Bondprozesses zur phasenweisen Auswahl in Abhängigkeit von Ausgangsdaten der Auswertungseinrichtung gespeichert sind.

13. Anordnung nach Anspruch 12, wobei die Auswertungseinrichtung einen Referenzkurvenspeicher zur Speicherung von in die drei Kurvenabschnitte differenzierten Referenzkurven und eine Vergleichereinheit zum Vergleich der Kurvenform der aktuellen Zeitabhängigkeit des oder der erfassten Bondparameter mit den Referenzkurven und zur Ausgabe von die drei Zeitabschnitte definierenden Daten aufweist.

14. Anordnung nach Anspruch 12 oder 13, wobei die Bondparameter-Steuereinrichtung ein Rückkopplungsglied zur Realisierung einer Regelungskomponente bei der Steuerung mindestens eines Bondparameters aufweist.

15. Drahtbonder mit einer Anordnung nach einem der Ansprüche 12 bis 14.
